# EUROPÄISCHE PATENTSCHRIFT

(11) **EP 0 623 961 B1**
(45) Veröffentlichungstag und Bekanntmachung des Hinweises auf die Patenterteilung: **21.11.2001**
(21) Anmeldenummer: 94106457.8
(22) Anmeldetag: 26.04.1994
(51) Int. Cl.: H01L 29/73, H01L 29/737, H01L 29/36

(54) **Bipolar-Transistor mit hoher Stromverstärkung**
Bipolar transistor with a large current gain
Transistor bipolaire ayant un gain en courant élevé

(30) Priorität: 06.05.1993 DE 4314951
(43) Veröffentlichungstag der Anmeldung: 09.11.1994
(73) Patentinhaber: DaimlerChrysler AG, 70567 Stuttgart (DE)
(72) Erfinder: Jorke, Helmut, D-89547 Gerstetten (DE)
(74) Vertreter: Fröhling, Werner Otto, Dr.

(56) Entgegenhaltungen:
- EP-A- 0 333 997
- DE-A- 4 039 103
- PATENT ABSTRACTS OF JAPAN vol. 10, no. 356 (E-459) (2412) 29. November 1986 & JP-A-61 154 071 (FUJITSU LTD) 12. Juli 1986
- IEEE ELECTRON DEVICE LETTERS, Bd.11, Nr.10, Oktober 1990, NEW YORK US Seiten 428 - 430 R.L. WANG ET AL. 'Negative differential resistance of a delta-doping-induced double-barrier quantum-well diode at room temperarure'

## Beschreibung

Die Erfindung betrifft einen Bipolar-Transistor nach dem Oberbegriff des Patentanspruch 1.

Volumendotierte Homo-und Hetero-Bipolartransistoren (BJT, HBT) sind Stand der Technik und finden Verwendung in digitalen Schaltungen, Hochfrequenzschaltungen und in der Leistungselektronik.

Desweiteren sind Transistoren bekannt, die eine planar dotierte Barriere (PDB) besitzen und der Ladungsträgertransport mittels thermionischer Emission erfolgt (Luryi und Kazarinov, Applied Physics A28, 151 (1982)).

Bei diesem Transistor-Typ findet Elektronen-Emission aus dem Emitter in den Kollektor vermittels thermionischer Anregung über eine Barriere (die Basis) statt. Die Grundidee besteht darin, über ein Gate-Potential (Poly-Si Gate) die Höhe der PDB zu variieren und damit den thermionischen Strom vom Emitter (n⁺-Substrat) zum Kollektor (Anode) zu steuern.

Außerdem kann die Steuerung der Höhe der PDB über den Basisanschluß und nicht über ein Gate-Potential erfolgen. Diese basisgesteuerte Transistorstruktur kann daher als modifizierter Bipolar-Transistor (BJT, HBT) betrachtet werden, wobei die thermionische Emission Drift- und Diffusionsprozesse im Injektionsbereich ersetzt. In den Transistor sind gering dotierte Zonen eingebaut, die die Tunnelleckströme reduzieren und die Sperrschicht-Kapazitäten verringern. Dadurch lassen sich extrem hohe Dotierungen im Emitter und in der Basis verwenden, was einerseits den Emitterkontakt-Widerstand verringert und andererseits zu einem sehr geringen Basisbahnwiderstand führt. Ein derartiger Transistor ist in der nicht vorveröffentlichten deutschen Patentanmeldung DE-A-4 341 941 beschrieben.

Aus der Druckschrift DE-A-40 39 103 bekannt ist eine bipolare Halbleiteranordnung, die aus mehreren Delta-Dotierebenen mit Dotierstoffen beider Leitfähigkeitstypen in verschiedenen Dotierebenen aufgebaut. Derartige bipolare Anordnungen sind für schnelle elektronische Schaltkreise geeignet.

Die Aufgabe der Erfindung liegt darin, einen Bipolar-Transistor mit hoher Stromverstärkung, einem geringen Basis-Bahnwiderstand und günstigem Rauschverhalten herzustellen.

Die Aufgabe wird gelöst durch die im kennzeichnenden Teil des Patentanspruchs 1 angegebenen Merkmale. Vorteilhafte Ausgestaltungen und/oder Weiterbildungen sind den Unteransprüchen zu entnehmen.

Die erfindungsgemäße Transistorstruktur hat den Vorteil, daß unter den symmetrischen Potentialbedingungen (V_{EC} =V_{EC*} und V_{EB} =V_{EB*}) z.B. Elektronen aus der Emitterschicht E in die erste Kollektorschicht C und die zweite Kollektorschicht C* injiziert werden. Gleichzeitig werden Löcher aus der ersten Basis B in die zweite Basis B* und umgekehrt injiziert. Dieser Betrieb vermeidet die Rekombination von rückinjizierten Löchern im Emitter (wie beim herkömmlichen Bipolar-Transistor) und bedingt eine sehr hohe Stromverstärkung. In vorteilhafterweise werden anderseits auch bei sehr hohen Basisdotierungen, d.h. bei geringem Basis-Bahnwiderstand noch brauchbare Stromverstärkungen erreicht.

Die einzelnen Dotierebenen der Transistorstruktur, d.h. die Basisschichten B, B*, die Kollektorschichten C, C* und die Emitterschicht E können durch nachträgliche Metallisierung zur Herstellung der Kontakte auf gesonderte Potentiale gelegt werden. Mit den Begriffen zweite Basis und zweite Kollektor wird die jeweils symetrisch bzgl. der Emitterschicht angeordnete weitere Basis- und Kollekterschicht C*, B* bezeichnet.

Die Erfindung wird anhand von Ausführungsbeispielen beschrieben unter Bezugnahme auf schematische Zeichnungen.
- Fig. 1: zeigt den Schichtaufbau des Transistors.

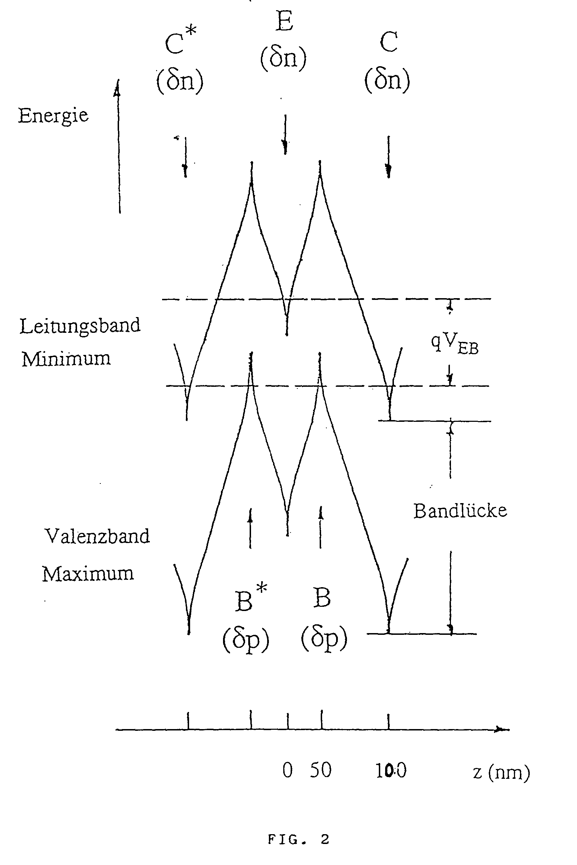

- In Fig. 2: ist ein Energiebänder-Diagramm dargestellt.

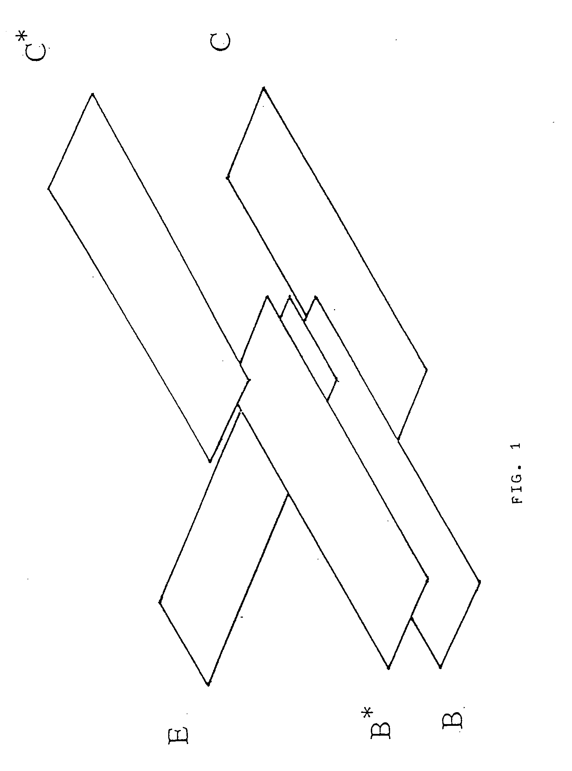

In Fig. 1 ist eine δn-i-δp-i-δn-i-δp-i-δn-Transistorstruktur dargestellt mit einer Flächendotierung δp der Basisschichten von z.B. 2 10¹³ cm⁻² und einer Flächendotierung δn der Emitter-und Kollektorschichten von z.B. 4 10¹³ cm⁻². Die Transistorstruktur ist symmetrisch aufgebaut, derart, daß ober- und unterhalb der Emitterschicht E jeweils
eine erste Basis- bzw. zweite Basisschicht B, B* und eine erste Kollektor- bzw. zweite Kollektorschicht C, C* angeordnet ist.

Die δ-dotierten Bereiche sind in intrinsisches Halbleitermaterial eingebettet. Zwischen Basis-und Emitterdotierung beträgt die Schichtdicke des intrinsisches Halbleitermaterials z.B. 50nm und zwischen Kollektor- und Basisdotierung etwa 100nm. Dabei bildet der Bereich zwischen Kollektor-und Basisdotierung die Driftzone und der Bereich zwischen Basis- und Emitterdotierung die Injektionszone.

Eine derartige Transistorstruktur entspricht der eines Bipolar-Bauelements, da jede δ-Schicht auf gesondertes Potential gelegt werden kann. Unter symmetrischen Potentialbedingungen V_{EB}=V_{EB*}und V_{EC}=V_{EC*} (mit V = Potentialdifferenz) ergibt sich eine Barrierenstruktur analog der eines Bipolar-Junctiontransistors (BJT). Die Elektronen werden von der Emitterschicht E in die Kollektorschichten C, C* injiziert, wobei die Basisschichten B, B* als Barriereschichten wirken. Zusätzlich werden Löcher über die Emitterbarriere von der Basis B in die symmetrische zweite-Basis B* und umgekehrt injiziert. Im Gegensatz zum konventionellen BJT werden die zurückinjizierten Löcher nicht im Emitter gesammelt, wo sie schließlich rekombinieren, sondern in der zweiten-Basis. Dadurch wird eine sehr viel größere Stromverstärkung erzielt.

Ein Vergleich der Werte der Stromverstärkung von konventionellen Silizium BJT's, die eine typische Stromverstärkung von 100 aufweisen, mit einem erfindungsgemäßen Bipolartransistor, der aus Silizium aufgebaut ist, ergibt Stromverstärkungen, die um mehr als zwei Größenordnungen höher liegen, etwa bei einer Stromverstärkung von 3x10⁴ bei einer Ladungsträgerlebensdauer von 1*µ*s. Dabei kann die Basisdotierung auf 2·10¹⁴ cm⁻² ansteigen, was einem Bahnwiderstand von weniger als 1kΩ/cm² entspricht, ohne daß die Stromverstärkung auf geringere Werte als in konventionellen BJT's abnimmt.

In einem weiteren Ausführungsbeispiel kann die erfindungsgemäße Transsistorstruktur aus fünf Halbleiterschichten bestehen, die endlich breite Dotierbereiche besitzen. Zum Beispiel kann eine n-i-p-i-n-i-p-i-n-Struktur hergestellt werden, wobei die einzelnen Schichten innerhalb einer Dicke von etwa 20nm dotiert sind mit z.B. einer n-Dotierung von 2·10¹⁹ cm⁻³ und einer p-Dotierung von 1·10¹⁹ cm ⁻ ³.

Sowohl bei der δ-dotierten Struktur als auch bei der Transistorstruktur mit endlichen Dotierbereichen können die intrinsischen Halbleiterbereiche gering dotiert sein, z.B. eine n-Dotierung von etwa 10¹⁷ cm⁻³ aufweisen.

Als Halbleitermaterialien eignen sich z.B. Si oder eine Si/SiGe-Heterostruktur-Schichtenfolge. Wird eine Si/SiGe-Heterostruktur zur Herstellung des Transistors verwendet, so ist es vorteilhaft die Driftzone, d.h. die Bereiche B-C und B*-C* aus einer SiGe Halbleitersschicht herzustellen, da dadurch höhere Driftgeschwindigkeiten erzielt werden. Geeignete Dotierstoffe für die n-Dotierung sind Antimon und für die p-Dotierung Bor.

Die erfindungsgemäße Transistorstruktur kann aber auch aus Heterostrukturen aus III/V-Halbleitermaterialien hergestellt werden, z.B. GaAs, GaAlAs, GaInAs, InP.

Desweiteren ist die Erfindung nicht auf die in den Ausführungsbeispielen angegebene Transistorstruktur beschränkt, sondern es sind auch Transistoren mit p-in-ip-in-ip- bzw. δp-iδn-iδp-iδn-iδp-Strukturen herstellbar.

Die Schichtenfolge aus der ersten Kollektorschicht C, ersten Basisschicht B, Emitterschicht E, zweiten Basisschicht B* und zweiten Kollektorschicht C* kann gemäß einer vorteilhaften Weiterbildung der Erfindung periodisch fortgesetzt sein mit jeweils vollständigen Schichtenfolgen von erster Kollektorschicht bis zweiter Kollektorschicht (C-B-E-B*-C*) als eine Periode. Dabei kann vorteilhafterweise die erste Kollektorschicht C einer Periode identisch sein mit der zweiten Kollektorschicht einer angrenzenden Periode.

## Patentansprüche

1. Bipolar-Transistor mit einer Emitterschicht, Basisschicht und einer Kollektorschicht,
**dadurch gekennzeichnet,**
**daß** der Transistor mindestens eine Schichtenfolge mit einem bezüglich der Emitterschicht symmetrischen Schichtaufbau, bestehend aus einer ersten Kollektorschicht (C), einer ersten Basisschicht (B), der Emitterschicht (E), einer zweiten Basisschicht (B*) und einer zweiten Kollektorschicht (C*) besitzt.

2. Bipolar-Transistor nach Anspruch 1, **dadurch gekennzeichnet, daß** die Schichtenfolge aus Halbleiterschichten und dotierten Bereichen besteht, daß die dotierten Bereiche die Emitterschicht, die Basisschichten und die Kollektorschichten bilden, daß die Halbleiterschichten intrinsisch sind oder eine geringe Dotierung von etwa 10¹⁷ cm⁻³ aufweisen, und daß die Halbleiterschichten eine zwischen der ersten Kollektorschicht und der ersten Basisschicht angeordnete erste Driftzone, eine zwischen der zweiten Kollektorschicht und der zweiten Basisschicht angeordnete zweite Driftzone, eine zwischen der ersten Basisschicht und der Emitterschicht angeordnete erste Injektionszone und eine zwischen der zweiten Basisschicht und der Emitterschicht angeordnete zweite Injektionszone bilden.

3. Bipolar-Transistor nach Anspruch 2, **dadurch gekennzeichnet, daß** die Emitterschicht eine n-Dotierung, die Basisschichten eine p-Dotierung und die Kollektorschichten eine n-Dotierung, oder die Emitterschicht eine p-Dotierung, die Basisschichten eine n-Dotierung und die Kollektorschichten eine p-Dotierung aufweisen.

4. Bipolar-Transistor nach Anspruch 3, **dadurch gekennzeichnet, daß** die dotierten Bereiche δ-dotierte Bereiche sind.

5. Bipolar-Transistor nach einem der Ansprüche 2 bis 4, **dadurch gekennzeichnet, daß** die Driftzonen aus einem anderen Halbleitermaterial als die Injektionszonen bestehen.

6. Bipolar-Transistor nach einem der vorhergehenden Ansprüche, **dadurch gekennzeichnet, daß** sich die Schichtenfolge im Transistor periodisch wiederholt.

7. Bipolar-Transistor nach Anspruch 6, **dadurch gekennzeichnet, daß** die erste Kollektorschicht (C) einer Schichtenfolge und die zweite Kollektorschicht (C*) einer angrenzenden Schichtenfolge identisch sind.

## Claims

1. Bipolar transistor having an emitter layer, base layer and a collector layer
**characterized in that** the transistor has at least one layer sequence having a layer structure that is symmetrical with respect to the emitter layer, comprising a first collector layer (C), a first base layer (B), the emitter layer (E), a second base layer (B*) and a second collector layer (C*).

2. Bipolar transistor according to claim 1,
**characterized in that** the layer sequence comprises semiconductor layers and doped regions, **in that** the doped regions form the emitter layer, the base layers and the collector layers, **in that** the semiconductor layers are intrinsic or have a low doping of about 10¹⁷ cm⁻³, and **in that** the semiconductor layers form a first drift zone arranged between the first collector layer and the first base layer, a second drift zone arranged between the second collector layer and the second base layer, a first injection zone arranged between the first base layer and the emitter layer, and a second injection zone arranged between the second base layer and the emitter layer.

3. Bipolar transistor according to claim 2,
**characterized in that** the emitter layer has an n-type doping, the base layers have a p-type doping and the collector layers have an n-type doping, or the emitter layer has a p-type doping layer, the base layers have an n-type doping and the collector layers have a p-type doping.

4. Bipolar transistor according to claim 3,
**characterized in that** the doped regions are δ-doped regions.

5. Bipolar transistor according to one of claims 2 to 4, **characterized in that** the drift zones are composed of a different semiconductor material from that of the injection zones.

6. Bipolar transistor according to one of the preceding claims, **characterized in that** the layer sequence is periodically repeated in the transistor.

7. Bipolar transistor according to claim 6,
**characterized in that** the first collector layer (C) of a layer sequence and the second collector layer (C*) of an adjoining layer sequence are identical.

## Revendications

1. Transistor bipolaire présentant une couche émettrice, une couche formant base et une couche collectrice, **caractérisé en ce que** le transistor a au moins une séquence de couches avec une structure de couches symétrique par rapport à la couche émettrice, constituée d'une première couche collectrice (C), d'une première couche formant base (B), de la couche émettrice (E), d'une seconde couche formant base (B*) et d'une seconde couche collectrice (C*).

2. Transistor bipolaire selon la revendication 1,
**caractérisé en ce que** la séquence de couches est constituée par des couches semiconductrices et par des zones dopées, **en ce que** les zones dopées forment la couche émettrice, les couches formant base et les couches collectrices, **en ce que** les couches semiconductrices sont intrinsèques ou présentent un dopage réduit d'environ 10¹⁷ cm⁻³, et **en ce que** les couches semiconductrices forment une première zone de dérive disposée entre la première couche collectrice et la première couche formant base, une seconde zone de dérive disposée entre la seconde couche collectrice et la seconde couche formant base, une première zone d'injection disposée entre la première couche formant base et la couche émettrice et une deuxième zone d'injection disposée entre la seconde couche formant base et la couche émettrice.

3. Transistor bipolaire selon la revendication 2,
**caractérisé en ce que** la couche émettrice présente un dopage de type n, les couches formant base présentent un dopage de type p, et les couches collectrices un dopage de type n ou la couche émettrice présente un dopage de type p, les couches formant base présentent un dopage de type n et les couches collectrices un dopage de type p.

4. Transistor bipolaire selon la revendication 3,
**caractérisé en ce que** les zones dopées sont des zones de type δ.

5. Transistor bipolaire selon l'une des revendications 2 à 4, **caractérisé en ce que** les zones de dérive sont constituées d'un autre matériau semiconducteur que les zones d'injection.

6. Transistor bipolaire selon l'une des revendications précédentes, **caractérisé en ce que** la séquence de couches se répète périodiquement dans le transistor.

7. Transistor bipolaire selon la revendication 6,
**caractérisé en ce que** la première couche collectrice (C) d'une séquence de couches et la seconde couche collectrice (C*) d'une séquence de couches adjacente sont identiques.
